# DEMANDE DE BREVET EUROPEEN

(11) **EP 2 343 543 A1**
(43) Date de publication de la demande: **13.07.2011**
(21) Numéro de dépôt: 10197023.4
(22) Date de dépôt: 27.12.2010
(51) Int. Cl.: G01N 27/414, G01N 33/543, H01L 21/322

(54) **Capteur biologique à mesure électrochimique et/ou électrique et à électrode de diamant et circuit électronique intégrés**

(30) Priorité: 30.12.2009 FR 0959675
(71) Demandeur: COMMISSARIAT A L'ENERGIE ATOMIQUE ET AUX ENERGIES ALTERNATIVES, 75015 Paris (FR)
(72) Inventeur: Mazellier, Jean-Paul, 51100 Reims (FR)
(74) Mandataire: Ilgart, Jean-Christophe

(57) **Abrégé**

Capteur biologique (100) à mesure électrochimique et/ou électrique comprenant au moins :
- une électrode de mesure (112) apte à réaliser une mesure électrochimique et/ou électrique et comportant une portion d'une couche de diamant dopée (104) d'un substrat comportant un empilement comprenant une couche diélectrique (106) disposée entre la couche de diamant dopée et une couche de matériau semi-conducteur (108),
- un circuit électronique (114) d'amplification et/ou de traitement d'un signal électrique destiné à être délivré par l'électrode de mesure, relié électriquement à l'électrode de mesure et réalisé dans une portion de la couche de matériau semi-conducteur.

## Description

### DOMAINE TECHNIQUE

L'invention concerne un capteur biologique, également appelé biocapteur, à détection électrique, pouvant notamment être utilisé pour des applications de détection biologique portables de type PoC (« Point of Care » en anglais), et apte à réaliser des mesures et/ou des détections de molécules in vivo et/ou in vitro par détection électrochimique et/ou électrique de ces molécules.

L'invention s'applique par exemple aux domaines des soins médicaux, de l'alimentaire, des traitements industriels et de la surveillance environnemental, pour détecter des polluants, des micro-organismes, des protéines, des signaux électriques, etc.

### ÉTAT DE LA TECHNIQUE ANTÉRIEURE

Un biocapteur est un dispositif de mesure transformant un phénomène biochimique en un signal mesurable, par exemple un signal optique ou électrique. Une partie de ces biocapteurs utilisent un principe appelé "clé - serrure" : dans ce type de biocapteur, une surface fonctionnalisée du biocapteur, c'est-à-dire une surface sur laquelle des récepteurs biologiques adaptés aux molécules que l'on cherche à détecter ont été greffés, est immergée dans une solution à analyser. Si des molécules biologiques que l'on cherche à détecter, c'est-à-dire des molécules complémentaires aux récepteurs greffés, se trouvent dans la solution, une interaction et une fixation des molécules sur les récepteurs ont alors lieu. Le biocapteur détecte alors la présence de ces molécules complémentaires des récepteurs préalablement greffés.

La détection des molécules peut être réalisée optiquement, par exemple par fluorescence. Dans ce cas, soit la molécule à détecter est naturellement fluorescente, soit il convient de rendre ces molécules fluorescentes par greffage de marqueurs sur celles-ci. La présence de molécules fixées sur les récepteurs est alors détectée en illuminant au laser la surface fonctionnalisée du biocapteur, chaque marqueur ayant une réponse spécifique. On détecte alors spatialement la réponse en fluorescence et on en déduit la présence ou non des molécules que l'on cherche à détecter. Des propriétés optiques (spectre absorption, bioluminescence, ...), différentes de la fluorescence, peuvent également être utilisées pour détecter les molécules.

La détection optique des molécules a notamment pour avantages d'offrir une bonne sélectivité du fait de la double détection réalisée (cible-récepteur et cible-marqueur) et de permettre de réaliser simultanément des détections de différents types de molécules (détection de plusieurs cibles/molécules présentes dans une même solution, par différentes fonctionnalisations de la surface du biocapteur), par exemple lorsque le biocapteur est une puce à ADN.

Toutefois, une telle détection optique des molécules présente également plusieurs inconvénients :
- la fonctionnalisation de la surface demande une préparation contraignante ;
- le marquage des molécules à détecter ajoute des opérations contraignantes et pose des problèmes de réactivité en raison du temps nécessaire pour réaliser ce marquage ;
- l'instrumentation de détection nécessaire est contraignante et incompatible avec la réalisation un biocapteur portable.

De manière alternative, la détection des molécules peut être réalisée électriquement, de manière faradique (transfert de charge à travers une interface, par exemple par une mesure d'impédance, ...) ou non-faradique (utilisation de courants de déplacement ou d'effets électrostatiques).

D'autres biocapteurs, appelés biocapteurs électrochimiques, se basent sur des réactions rédox des molécules à détecter. Cette méthode électrochimique est une méthode purement électrique dans laquelle des molécules destinées à réagir de manière électrochimique avec les molécules à détecter sont greffées sur une électrode d'analyse du biocapteur, la réponse électrique de ces molécules étant ensuite détectée. Ces biocapteurs électrochimiques se basent sur une détection ampérométrique ou potentiométrique des molécules.

La détection ampérométrique est une technique reposant sur la détermination de l'intensité d'un courant qui traverse une cellule électrochimique à un potentiel imposé entre deux électrodes du biocapteur. Cette intensité de courant est fonction de la concentration des corps électroactifs qui seront oxydés ou réduits sur l'une des deux électrodes, appelée électrode de mesure, la seconde électrode servant d'électrode de référence.

La détection potentiométrique est une méthode électrochimique basée sur la mesure d'une différence de potentiels entre une électrode de mesure et une électrode de référence. Deux types de détection potentiométrique peuvent être utilisés. La première fait appel à une électrode de mesure (appelée ISE pour « Ion Sélective Electrode ») sur laquelle sont fixés des biorécepteurs et une seconde électrode de référence, le potentiel de l'électrode de mesure variant lorsque l'analyte (molécules que l'on cherche à détecter) réagit avec les biorécepteurs fixés sur l'électrode de mesure. La seconde fait appel à des transistors à effet de champ (FET pour « Field-Effect Transistor ») qui sont sensibles aux charges sur la surface des grilles des transistors. En modifiant ces grilles en une ISE, on obtient un dispositif ISFET (« ion sensitive field effect transistor ») sensible aux ions.

Il existe également des capteurs électrochimiques réalisant des mesures par spectroscopie d'impédance électrochimique (EIS pour « Electrochemical Impedance Spectroscopy »). Pour cela, une excitation sinusoïdale faible est superposée à une excitation constante impliquant une variation du courant à la même fréquence. Le rapport tension/courant (en complexe) donne alors l'impédance (en complexe) du système.

Ainsi, par rapport aux biocapteurs réalisant une détection optique des molécules, les biocapteurs électrochimiques ne nécessitent pas la mise en oeuvre d'un marquage moléculaire. De plus, ces biocapteurs peuvent réaliser des mesures en temps réel, être fabriqués à faible coût par des procédés standards de la microélectronique, sont peu encombrants, d'utilisation souple et autorise un multiplexage des détections réalisées.

Toutefois, les biocapteurs électrochimiques de l'art antérieur présentent également un certain nombre d'inconvénients :
- ils présentent un faible gain de transduction, ce qui réduit les seuils de détection ;
- ils nécessitent une préparation des surfaces des électrodes et font appels à des interférents électrochimiques (espèce ionique actives) ;
- ils introduisent des sources de chaleur, d'origine électronique, à proximité du milieu d'analyse, ce qui peut être critique pour les milieux biologiques présentant une forte sensibilité à la température.

Le document US 5 777 372 décrit l'utilisation de structures à base de diamant remplaçant les électrodes de métal des biocapteurs. Le diamant a notamment pour avantages d'être très résistant à la plupart des agents chimiques, non corrodable et offre des fenêtres d'activité supérieures à celle du platine par exemple. La fenêtre d'activité d'un matériau correspond à l'étendue de la gamme de tensions utilisables en milieu aqueux. Pour des potentiels au-delà de cette fenêtre, on obtient une réaction rédox de l'eau (le milieu) sur les électrodes, empêchant de détecter toute autre réaction. Une comparaison des fenêtres d'activité de différents matériaux, dont le diamant, est décrite dans le document de C.E. Nebel et al., « Diamond and biology ». Journal of the Royal Society Interface, 4, pages 439-461, 2007.

Un tel biocapteur a toutefois pour inconvénient que l'électronique de mesure du biocapteur est formée par un analyseur externe auquel est relié le biocapteur. Le blindage nécessaire de la mesure pose alors un problème car, étant donné que les niveaux de courant sont très faibles (pouvant être de l'ordre du picoampère), il est nécessaire d'insérer le biocapteur dans une cage de Faraday performante. De plus, des contraintes importantes s'imposent quand à la qualité des câbles et de la connectique car le signal n'est amplifié qu'après être arrivé dans l'analyseur.

### EXPOSÉ DE L'INVENTION

Un but de la présente invention est de proposer un nouveau type de capteur biologique présentant les avantages des biocapteurs utilisant des électrodes à base de diamant, mais qui ne présente pas les inconvénients des biocapteurs dont l'électronique de mesure est déportée par rapport au reste du biocapteur.

Pour cela, la présente invention propose un capteur biologique, ou biocapteur, à mesure électrochimique et/ou électrique comprenant au moins :
- une électrode, par exemple une électrode de mesure, apte à réaliser une mesure électrochimique et/ou électrique et comportant au moins une portion d'une couche de diamant dopée d'un substrat comportant un empilement comprenant au moins une couche diélectrique disposée entre la couche de diamant dopée et une couche de matériau semi-conducteur ;
- un circuit électronique d'amplification et/ou de traitement d'au moins un signal électrique destiné à être délivré par l'électrode de mesure, relié électriquement à l'électrode de mesure et réalisé dans une portion de la couche de matériau semi-conducteur.

Le capteur selon l'invention applique un principe de détection basé sur des mesures électrochimiques et/ou électriques (potentiométrie, voltamétrie cyclique, ampérométrie, ...) qui peuvent être appliquées à la biologie soit via une interaction directe (mesure de couples redox, mesure de potentiels) ou via une interaction type clé-serrure lorsque l'électrode de mesure comporte des récepteurs biologiques greffés sur elle-même.

Le capteur selon l'invention utilise au moins une portion d'une couche de diamant dopée comme électrode de mesure servant d'interface électrique et chimique entre un milieu à analyser (biologiquement et/ou chimiquement) et un circuit électronique d'amplification et/ou de traitement. Le circuit électronique est donc intégré avec le reste du capteur, et notamment avec la ou les électrodes du capteur. Le terme « traitement » désigne tout type d'opération réalisée sur le signal électrique délivré par l'électrode : lecture, numérisation, etc.

L'utilisation de diamant dopé en tant qu'interface biologique permet donc de profiter des nombreux avantages de ce matériau : biocompatibilité, non toxicité, large fenêtre électrochimique, résilience, faible bruit, etc. Le fait de coupler et d'intégrer le diamant avec le circuit électronique permet de miniaturiser le capteur et de conférer au capteur une meilleure sensibilité car le capteur peut être facilement isolé des sources parasites extérieures. De plus, dans ce capteur, le circuit électronique permet de réaliser par exemple une amplification intégrée au plus proche de la mesure réalisée par l'électrode de mesure. De plus, un tel capteur autorise de réaliser une interface numérique (par le circuit électronique) dans le cas d'applications portables.

De plus, dans ce biocapteur, le signal est amplifié et/ou traité « à la source », ce qui limite les effets parasites du câblage et de l'environnement.

Le substrat peut être de type SOD (semi-conducteur sur diamant). Dans ce cas, du fait que la couche de matériau semi-conducteur et la couche de diamant fassent partie d'un même substrat SOD, le biocapteur comporte donc au moins une électrode réalisée dans une couche de diamant dopée physiquement liée à une couche de semi-conducteur dans laquelle le circuit électronique est réalisé, ces deux couches formant donc un unique bloc.

La couche diélectrique disposée entre la couche de diamant et la couche de matériau semi-conducteur permet notamment de protéger le diamant de flux d'oxygène à haute température utilisés lors de la réalisation du circuit électronique, car le diamant est très sensible à la présence d'oxygène à haute température (il combure dès 600°C en présence de O₂). De plus, cette couche diélectrique permet également d'isoler électriquement les électrodes du biocapteur vis-à-vis de la couche de matériau semi-conducteur, et éviter ainsi des interactions électriques entre les électrodes et le circuit électronique.

La couche de matériau semi-conducteur peut avoir une épaisseur inférieure ou égale à environ 1 µm, le circuit électronique pouvant comporter un ou plusieurs transistors de type PD-SOI (semi-conducteur sur isolant partiellement déserté) ou FD-SOI (semi-conducteur sur isolant totalement déserté). De tels transistors ont notamment pour avantages de présenter une faible consommation, des capacités parasites réduites et un faible bruit intrinsèque.

L'électrode de mesure peut être délimitée du reste de la couche de diamant par des tranchées remplies d'au moins un matériau diélectrique et traversant au moins la couche de diamant. Ces tranchées peuvent délimiter l'électrode de mesure du reste de la couche de diamant, mais également protéger le diamant formant l'électrode des flux d'oxygène lors de la réalisation du circuit électronique.

Le circuit électronique peut être relié électriquement à l'électrode de mesure par des vias traversant et au moins une couche d'interconnexions électriques à base d'au moins un matériau électriquement conducteur formés dans au moins une couche de passivation à base d'au moins un matériau diélectrique, la couche de matériau semi-conducteur pouvant être disposée entre la couche de diamant et la couche de passivation.

La couche de passivation, qui peut également être une multicouche formée par plusieurs couches de passivation superposées, peut être disposée entre une couche massive pouvant former un support mécanique du capteur et la couche de semi-conducteur. Ainsi, la couche de diamant peut former la quasi-totalité d'une surface du capteur exposée au milieu à analyser.

Dans une variante, au moins un trou réalisé à travers au moins la couche de passivation, la couche de matériau semi-conducteur et la couche diélectrique peut former un accès à l'électrode de mesure.

Le circuit électronique peut être relié électriquement à l'électrode de mesure par des vias traversant et au moins une couche d'interconnexions électriques à base d'au moins un matériau électriquement conducteur formés dans au moins une couche de passivation à base d'au moins un matériau diélectrique disposée contre la couche de matériau semi-conducteur, et dans lequel au moins un trou réalisé à travers au moins la couche de passivation forme un accès à l'électrode de mesure. Là encore, la couche de passivation peut également être une multicouche formée par plusieurs couches de passivation superposées les unes sur les autres.

L'électrode de mesure peut être disposée dans un creux formé au moins dans la couche de semi-conducteur.

Des récepteurs biologiques complémentaires des molécules destinées à être détectées par le capteur peuvent être greffés sur l'électrode de mesure. Ainsi, le capteur peut utiliser le principe de détection « clé - serrure ». De plus, il est également possible que des marqueurs des molécules cibles soient utilisés afin d'augmenter la sélectivité du processus clé-serrure, limitant les effets parasites liés à la détection de mauvaises cibles.

Le capteur peut comporter en outre une seconde électrode pouvant former une électrode de référence, ou une deuxième et une troisième électrodes pouvant former respectivement une électrode de référence et une contre-électrode, chaque électrode du capteur pouvant comporter au moins une portion de la couche de diamant. Ainsi, le capteur peut comporter l'ensemble de ses électrodes à base de diamant dopé intégrées avec le reste du capteur, et notamment avec le circuit électronique. Lorsque le capteur comporte deux électrodes, la mesure de la différence de potentiels entre l'électrode de mesure et l'électrode de référence permet de mesurer directement la concentration de l'analyte recherchée. Lorsque le capteur comporte trois électrodes, une tension entre l'électrode de travail, sur laquelle la réaction d'intérêt a lieu, et la contre électrode peut être ajustée pour établir une tension d'entrée de cellule souhaitée entre l'électrode de travail et l'électrode de référence. Il est toutefois possible d'avoir d'autres modes d'utilisation d'un tel capteur comportant deux ou trois électrodes. De plus, il est également possible que le capteur comporte plus de trois électrodes.

L'invention concerne également un procédé de réalisation d'un capteur biologique à mesure électrochimique et/ou électrique comportant au moins les étapes de :
- réalisation d'une électrode, par exemple une électrode de mesure, apte à réaliser une mesure électrochimique et/ou électrique et comportant au moins une portion d'une couche de diamant dopée d'un substrat comportant un empilement comprenant au moins une couche diélectrique disposée entre la couche de diamant dopée et une couche de matériau semi-conducteur ;
- réalisation, dans une portion de la couche de matériau semi-conducteur, d'un circuit électronique d'amplification et/ou de traitement d'un signal électrique destiné à être délivré par l'électrode de mesure ;
- réalisation d'une liaison électrique au moins entre l'électrode de mesure et le circuit électronique.

La réalisation de l'électrode de mesure peut être obtenue par la mise en oeuvre au moins des étapes suivantes :
- gravure de tranchées au moins à travers la couche de diamant, la couche de matériau semi-conducteur et la couche diélectrique, pouvant délimiter une portion de la couche de diamant destinée à former l'électrode de mesure ;
- remplissage des tranchées par au moins un matériau diélectrique.

La couche diélectrique disposée entre la couche de matériau semi-conducteur et la couche de diamant, ainsi que le matériau diélectrique disposé dans les tranchées, peuvent protéger la portion de diamant dopé formant l'électrode de mesure des flux d'oxygène à haute température pouvant être utilisés lors de la réalisation du circuit électronique.

La réalisation de la liaison électrique entre l'électrode de mesure et le circuit électronique peut être obtenue par la mise en oeuvre au moins des étapes suivantes :
- dépôt d'au moins une couche de passivation à base d'au moins un matériau diélectrique sur la couche de matériau semi-conducteur, pouvant recouvrir le circuit électronique ;
- réalisation de vias traversant à base d'au moins un matériau électriquement conducteur reliés électriquement à l'électrode de mesure et au circuit électronique à travers au moins la couche de passivation,
- réalisation d'une couche d'interconnexions électriques à base d'au moins un matériau électriquement conducteur sur la couche de passivation, telle qu'au moins une portion de la couche d'interconnexions électriques et les vias traversant peuvent relier électriquement l'électrode de mesure au circuit électronique.

Le procédé peut comporter en outre, après la réalisation de la liaison électrique entre l'électrode de mesure et le circuit électronique, une étape de dépôt d'au moins une seconde couche de passivation recouvrant au moins la couche d'interconnexions électriques, puis une étape de solidarisation de la seconde couche de passivation avec une couche massive formant un support mécanique du capteur.

Dans une variante, le procédé peut comporter en outre, après la réalisation de la liaison électrique entre l'électrode de mesure et le circuit électronique, une étape de gravure d'au moins un trou à travers au moins la couche de passivation, la couche de matériau semi-conducteur et la couche diélectrique, formant un accès à l'électrode de mesure.

La réalisation de l'électrode de mesure peut être obtenue par la mise en oeuvre au moins d'une étape de gravure de la couche de diamant.

La réalisation de l'électrode de mesure peut être obtenue par la mise en oeuvre au moins d'une étape de dépôt de la couche de diamant sur la couche diélectrique, la couche de diamant et au moins une portion de la couche diélectrique pouvant être disposées dans un creux formé au moins dans la couche de matériau semi-conducteur.

Le procédé peut comporter en outre, entre l'étape de réalisation de l'électrode de mesure et l'étape de réalisation du circuit électronique, une étape de gravure de la couche diélectrique telle qu'au moins une portion restante de la couche diélectrique puisse être disposée entre l'électrode de mesure et la couche de semi-conducteur, puis d'une étape de dépôt d'un matériau diélectrique pouvant recouvrir au moins l'électrode de mesure.

La réalisation de la liaison électrique entre l'électrode de mesure et le circuit électronique peut être obtenue par la mise en oeuvre au moins des étapes suivantes :
- dépôt d'au moins une couche de passivation à base d'au moins un matériau diélectrique sur la couche de matériau semi-conducteur, pouvant recouvrir le circuit électronique et l'électrode de mesure,
- réalisation de vias traversant à base d'au moins un matériau électriquement conducteur reliés électriquement à l'électrode de mesure et au circuit électronique à travers au moins la couche de passivation,
- réalisation d'une couche d'interconnexions électriques à base d'au moins un matériau électriquement conducteur sur la couche de passivation, telle qu'au moins une portion de la couche d'interconnexions électriques et les vias traversant peuvent relier électriquement l'électrode de mesure au circuit électronique.

Le procédé peut comporter en outre, après la réalisation de la liaison électrique entre l'électrode de mesure et le circuit électronique, une étape de gravure d'au moins un trou à travers au moins la couche de passivation, pouvant former un accès à l'électrode de mesure.

La ou les étapes mises en oeuvre pour la réalisation de l'électrode de mesure peuvent réaliser également une seconde électrode formant une électrode de référence, ou une deuxième et une troisième électrode formant respectivement une électrode de référence et une contre-électrode, chaque électrode du capteur pouvant comporter au moins une portion de la couche de diamant.

Le procédé peut comporter en outre une étape de greffage de récepteurs biologiques complémentaires de molécules destinées à être détectées par le capteur sur l'électrode de mesure.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1F représentent les étapes d'un procédé de réalisation d'un capteur biologique, objet de la présente invention, selon un premier mode de réalisation,
- la figure 1G représente un capteur biologique, objet de la présente invention, selon une variante du premier mode de réalisation,
- les figures 2A à 2D représentent les étapes d'un procédé de réalisation d'un capteur biologique, objet de la présente invention, selon un deuxième mode de réalisation,
- les figures 3A à 3D représentent les étapes d'un procédé de réalisation d'un capteur biologique, objet de la présente invention, selon un troisième mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

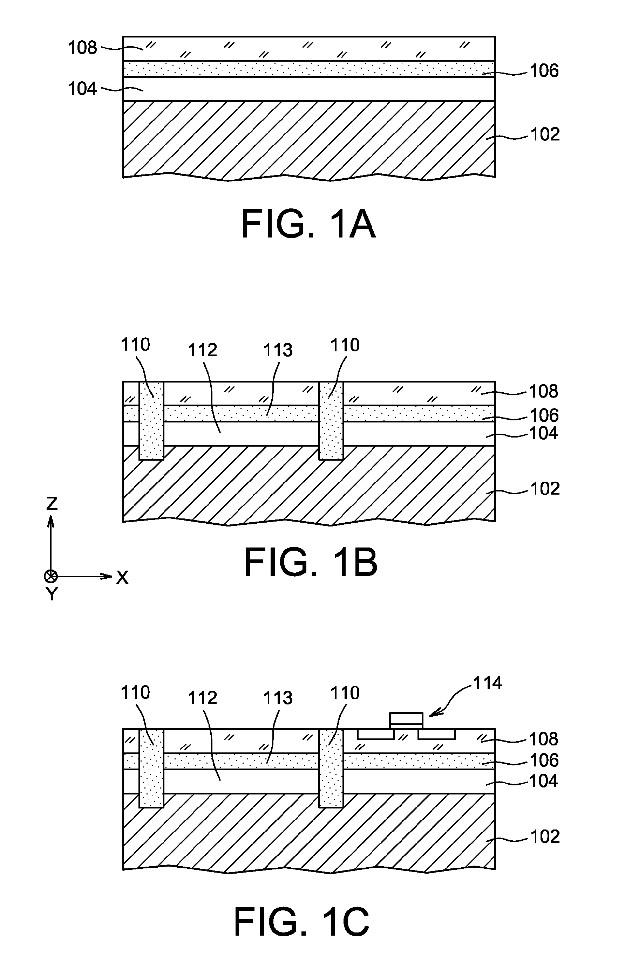

On se réfère tout d'abord aux figures 1A à 1F qui représentent les étapes d'un procédé de réalisation d'un capteur biologique 100, ou biocapteur, à mesure électrochimique et/ou électrique selon un premier mode de réalisation. Sur ces figures 1A à 1F, seule la réalisation d'une partie du biocapteur 100 est représentée.

Comme représenté sur la figure 1A, le biocapteur 100 est réalisé à partir d'un substrat SOD, c'est-à-dire un substrat de type semi-conducteur sur diamant, comportant une couche arrière 102 servant de support mécanique, une couche de diamant dopé 104, une couche barrière 106 et une couche superficielle 108 à base de semi-conducteur, ici du silicium.

La couche de diamant 104 est disposée entre la couche arrière 102 et la couche barrière 106, et la couche barrière 106 est disposée entre la couche de diamant 104 et la couche superficielle 108.

La couche superficielle 108 est de préférence une couche mince d'épaisseur inférieure ou égale à environ 1 µm. La couche barrière 106 est à base d'un matériau diélectrique, tel que de l'oxyde de semi-conducteur ou du nitrure de semi-conducteur (par exemple du SiO₂ ou du SiN), et a par exemple une épaisseur comprise entre environ 50 nm et 1 µm. Le matériau de la couche barrière 106, ainsi que l'épaisseur de la couche barrière 106, sont choisis afin d'isoler électriquement la couche de diamant 104 de la couche de semi-conducteur 108, mais également afin de protéger la couche de diamant dopé 104 de flux d'oxygène à hautes températures utilisés pendant la réalisation ultérieure de circuits électroniques dans la couche superficielle 108. En effet, le diamant est comburé sous oxygène dès 600°C. Or, les processus thermiques mis en oeuvre lors de la réalisation de circuits électroniques utilisent l'oxygène à des températures supérieures ou égales à environ 600°C, par exemple lors de la formation de la grille d'un transistor par oxydation thermique.

Le diamant dopé de la couche 104 peut être de type polycristallin CVD (déposé chimiquement en phase vapeur), HOD (diamant fortement orienté) ou encore du type monocristallin intrinsèque, et par exemple dopé de préférence au bore (type p), ou au phosphore (type n). L'épaisseur de la couche de diamant 104 peut être comprise entre environ 100 nm et 1 µm.

Bien que cela ne soit pas visible sur la figure 1A, la couche de diamant 104 comporte une structure granulaire. En effet, le diamant synthétique est généralement formé sur un hétérosubstrat, c'est-à-dire un substrat à base d'un matériau autre que du diamant (ici du silicium), ce qui implique, compte tenu du procédé de croissance mis en oeuvre pour former le diamant, que le diamant comporte une structure granulaire avec une évolution des grains dans le sens de l'épaisseur du matériau (formant une couche de diamant de type colonnaire). Or, la base des grains qui est la partie de la couche de diamant formée au début de la croissance du diamant, appelée partie de nucléation, c'est-à-dire celle se trouvant contre le substrat, est généralement défectueuse électriquement en raison de la présence d'un nombre important de joints de grains, de graphite, etc. Cette partie de nucléation peut se trouver de préférence du côté de la couche arrière 102, ou du côté de la couche barrière 106.

Enfin, la couche arrière 102 est ici une couche massive de semi-conducteur, par exemple à base de silicium, d'épaisseur supérieure ou égale à environ 10 µm.

Les étapes de réalisation d'un tel substrat SOD sont connues de l'état de la technique (report de couches, collage moléculaires, ...) et ne sont donc pas détaillées ici.

On réalise ensuite, à travers la couche superficielle 108, la couche barrière 106 et la couche de diamant dopé 104, des tranchées 110 délimitant dans la couche de diamant dopé 104 les électrodes actives du biocapteur 100. Ces tranchées 110 sont également réalisées en partie dans la couche arrière 102. Le biocapteur 100 peut comporter par exemple deux ou trois électrodes (électrode de mesure/électrode de référence/contre-électrode). Sur l'exemple de réalisation représenté sur les figures 1A à 1F, seule l'électrode de mesure, référencée 112, du biocapteur 100 est représentée. Ces tranchées 110 sont par exemple réalisées en gravant la totalité de l'épaisseur des couches 108, 106, 104 et une partie de l'épaisseur de la couche arrière 102, puis en remplissant les tranchées gravées 110 avec un matériau diélectrique biocompatible, par exemple à base d'oxyde ou de nitrure de semi-conducteur (tel que du SiO₂ ou du SiN) ou du diamant intrinsèque. On voit sur la figure 1B qu'une portion 113 de la couche barrière 106, de dimensions sensiblement similaires à celles de l'électrode de mesure 112, est apte à protéger l'électrode de mesure 112 de flux d'oxygène à haute température utilisés lors de la réalisation de circuits électroniques dans la couche superficielle 108. Le matériau utilisé pour remplir les tranchées 110 est également choisi afin que celui-ci fasse également office de barrière à la diffusion de l'oxygène à haute température vis-à-vis de l'électrode de mesure 112 lors de la réalisation de circuits électroniques dans la couche superficielle 108.

Le choix des dimensions des électrodes réalisées dans la couche de diamant dopé 104 est fonction de l'épaisseur de la couche de diamant 104. La dimension minimum d'une électrode, dans le plan (X,Y) représenté sur la figure 1B, correspondant par exemple à la longueur d'un côté de l'électrode lorsque celle-ci a une forme sensiblement rectangulaire, pourra être choisie sensiblement égale à l'épaisseur de la couche de diamant. Le choix des dimensions des électrodes du biocapteur 100 sera toutefois réalisé en prenant en compte d'autres considérations, telles que la quantité minimum de signal à obtenir pour une électrode, la faisabilité technologique de réalisation d'électrodes de tailles réduites, etc. Ainsi, d'une manière générale, les dimensions de l'électrode peuvent être choisies telles qu'environ une centaine de grains de la couche de diamant dopé 104 soient présents sous l'une des électrodes du biocapteur 100. Les dimensions des électrodes, dans le plan (X,Y) représenté sur la figure 1B, sont par exemple comprises entre environ 10 µm et 100 µm.

On réalise ensuite les circuits électroniques du biocapteur 100 selon les procédés standards de microélectronique, dans la couche superficielle 108. Sur la figure 1C, un seul transistor MOS d'un circuit électronique 114 est représenté. Le circuit électronique 114 forme ici un amplificateur du signal électrique généré aux bornes des électrodes du biocapteur 100. Dans le cas présent, la sortie du circuit électronique 114 est reliée à l'entrée d'un circuit de lecture et de numérisation qui est commun avec d'autres biocapteurs. Dans une variante, le circuit électronique 114 peut, outre la fonction d'amplification, également réaliser une fonction de lecture et/ou de conversion analogique/numérique du signal. Lorsque la couche superficielle 108 est une couche mince d'épaisseur inférieure ou égale à environ 1 µm, le circuit électronique 114 peut comporter des éléments, par exemple des transistors, de type PD-SOI, c'est-à-dire à déplétion partielle, ou FD-SOI, c'est-à-dire à déplétion totale.

Lors de la réalisation du circuit électronique 114, des flux d'oxygène à haute température traversent la couche superficielle 108, par exemple lors d'une étape d'oxydation du semi-conducteur de la couche superficielle 108. Les matériaux diélectriques de la couche barrière 106 et des tranchées 110 protègent alors la couche de diamant 104 et la couche arrière 102 de ces flux d'oxygène qui, en l'absence de la couche barrière 106 et/ou des tranchées 110, entraineraient une combustion du diamant et dégraderaient de manière irréversible la couche de diamant 104.

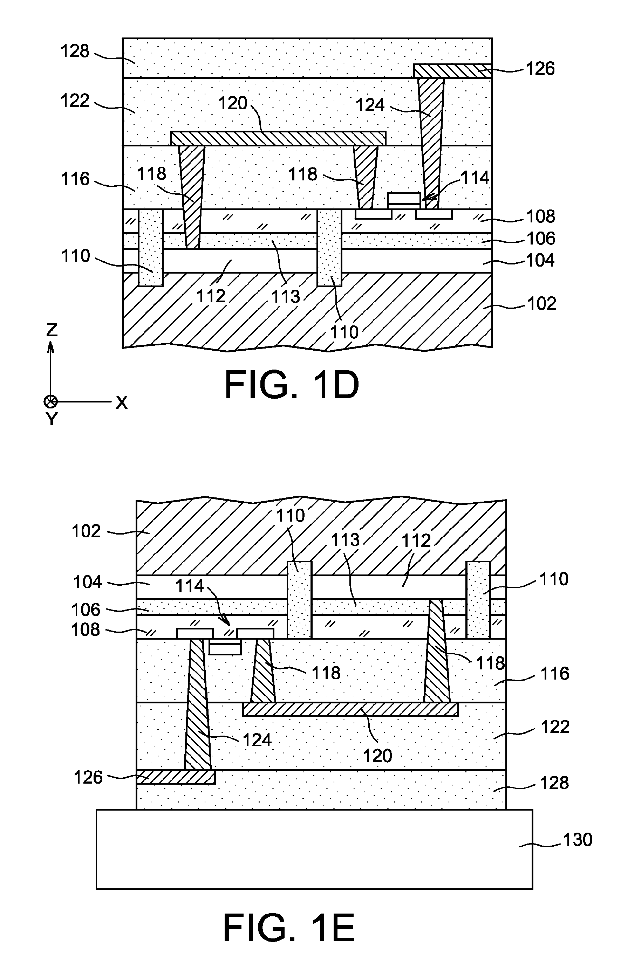

On réalise ensuite des interconnexions électriques sur plusieurs niveaux afin de relier électriquement les électrodes de diamant dopé du biocapteur 100 au circuit électronique 114. Sur l'exemple de la figure 1D, on réalise tout d'abord le dépôt d'une première couche de passivation 116 à base d'un matériau diélectrique, recouvrant la couche superficielle 108 et le circuit électronique 114. Des vias traversant 118 à base d'un matériau électriquement conducteur sont ensuite réalisés à travers la couche de passivation 116, la couche superficielle 108 et la couche barrière 106, et en partie dans l'électrode de mesure 112, pour venir contacter électriquement le circuit électronique 114 et l'électrode de mesure 112. Ensuite, une première couche d'interconnexions électriques 120, par exemple à base d'aluminium et/ou de tout autre matériau électriquement conducteur adapté, est formée sur la couche de passivation 116, permettant de relier électriquement, grâce aux vias 118, l'électrode de mesure 112 au circuit électronique 114. La couche d'interconnexions électriques 120 est enfin recouverte par une seconde couche de passivation 122. Sur l'exemple de la figure 1D, un autre via traversant 124 est réalisé à travers les deux couches de passivation 116, 122 pour venir contacter électriquement le circuit électronique 114. Bien que non représenté, au moins un autre via traversant est réalisé à travers les deux couches de passivation 116, 122 pour venir contacter électriquement un autre élément, par exemple une autre électrode du biocapteur 100. Une seconde couche d'interconnexions électriques 126 est ensuite réalisée sur la seconde couche de passivation 122 pour relier électriquement le circuit électronique 114 au dit autre élément du biocapteur 100. La seconde couche d'interconnexions électriques 126 est enfin recouverte d'une troisième couche de passivation 128. Les couches de passivation 116, 122 et 128 ont par exemple chacune une épaisseur égale à environ 400 nm.

Sur l'exemple décrit ci-dessus, le biocapteur 100 comporte deux niveaux d'interconnexions électriques. Toutefois, le biocapteur 100 peut comporter un nombre plus important de niveaux d'interconnexions, par l'exemple lorsque le biocapteur 100 comporte trois électrodes. De plus, les couches de passivation réalisées peuvent être vues comme une multicouche dans laquelle les différents niveaux d'interconnexions électriques sont réalisés.

Afin de réaliser les mesures électrochimiques avec les électrodes actives de diamant dopé, on peut retirer des portions de la couche arrière 102 recouvrant ces électrodes pour les libérer. Ceci peut être réalisé par une gravure localisée de la couche arrière 102 par tranchées profondes. Sur l'exemple de la figure 1D, cette gravure peut être réalisée au niveau de l'électrode de mesure 112.

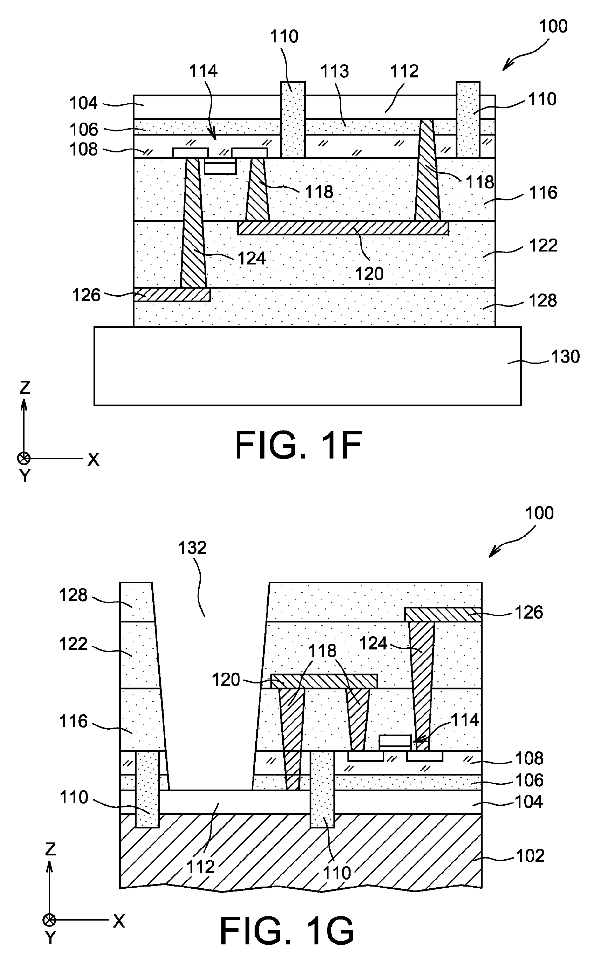

Dans une variante, et comme cela est représenté sur les figures 1E et 1F, il est possible de supprimer en intégralité la couche arrière 102, permettant au dispositif 100 de présenter une surface planaire en grande partie à base de diamant, augmentant la biocompatibilité du biocapteur 100 avec le milieu à analyser. Pour cela, on reporte les éléments précédemment réalisés sur une poignée mécanique 130, par exemple à base de verre ou de semi-conducteur, en solidarisant la couche de passivation 128 à la poignée mécanique 130 (figure 1E). Cette poignée 130 peut être prévue pour réaliser un contact électrique avec les sorties du circuit électronique 114 pour l'extraction des mesures. Dans ce cas, des contacts électriques reliés aux couches d'interconnexions électriques précédemment réalisées traversent la poignée 130 afin de pouvoir accéder à ces contacts depuis la face de la poignée opposée à celle solidarisée à la couche de passivation 128.

Enfin, comme représenté sur la figure 1F, une fois la couche de passivation 128 solidarisée à la poignée 130, on supprime la couche arrière 102, par exemple par un meulage ou une attaque chimique, révélant la couche de diamant 104.

Dans une variante, il est possible de structurer les électrodes actives à base de diamant dopé en forme de pointes, par exemple par un traitement sous plasma d'oxygène mis en oeuvre avec un masquage adapté au-dessus des électrodes (le masque étant par exemple à base d'aluminium). De telles électrodes sont par exemple utilisées pour former des matrices de pointes permettant de sonder des réseaux neuronaux (le facteur de forme étant dans ce cas important). De telles électrodes pourront être obtenues à partir d'une couche de diamant d'épaisseur égale à quelques dizaines de microns par exemple (par exemple supérieure à environ 20 µm).

En variante du procédé de réalisation précédemment décrit en liaison avec les figures 1A à 1F, il est possible de réaliser le capteur biologique 100 tel que représenté sur la figure 1G. Pour cela, les étapes précédemment décrites en liaison avec les figures 1A à 1C sont mises en oeuvre. On réalise ensuite les vias traversant 118, 124 et les couches d'interconnexions électriques 120, 126 dans les couches de passivation 116, 122 et 128 par les mêmes étapes que celles précédemment décrites en liaison avec la figure 1D. Toutefois, le ou les vias 118 réalisés en contact avec l'électrode de mesure 112 sont disposés à la périphérie de celle-ci pour que la réalisation ultérieure d'un trou 132 à travers les couches de passivation 116, 122, 128, la couche de matériau semi-conducteur 108 et la couche diélectrique 106, formant un accès à l'électrode de mesure 112, ne détériore pas ces interconnexions. Des zones d'isolation électrique, non représentées sur la figure 1G, pourront être réalisées dans la couche arrière 102, sous l'électrode de diamant 112.

Dans une autre variante du capteur 100 précédemment décrit en liaison avec la figure 1F, il est possible que le circuit électronique 114 ne soit pas réalisé à côté de l'électrode de mesure 112 comme c'est le cas sur la figure 1F, mais superposé à celle-ci. Dans ce cas, la projection d'une section de la première électrode 112 dans le plan (X,Y) (axes X et Y représentés sur la figure 1F) se superpose à la projection d'une section du circuit électronique 114 dans ce même plan. Dans ce cas, le circuit électronique 114 est entouré par les tranchées 110 remplies de matériau diélectrique. Une telle variante sera possible si la taille souhaitée de l'électrode 112 ainsi que l'encombrement des interconnexions électriques et du circuit électronique le permettent.

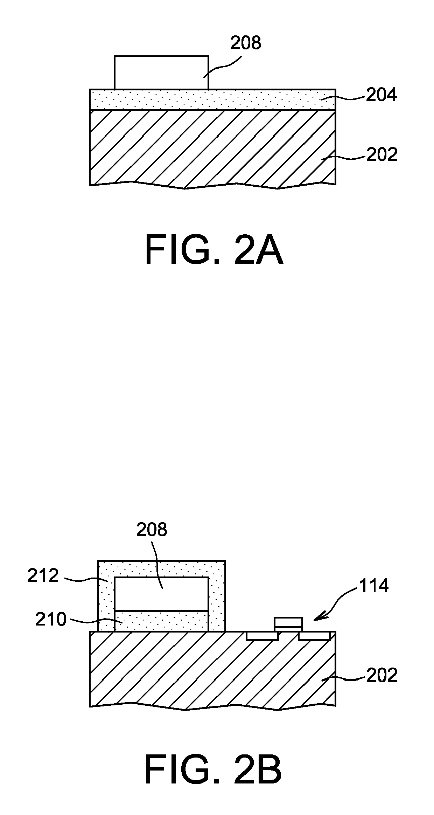

On se réfère maintenant aux figures 2A à 2D qui représentent les étapes d'un procédé de réalisation d'un capteur biologique à mesure électrochimique 200 selon un deuxième mode de réalisation. Sur ces figures 2A à 2D, seule la réalisation d'une partie du biocapteur 200 est représentée.

Dans ce second mode de réalisation, le dispositif 200 est réalisé à partir d'un substrat comportant une couche arrière 202, par exemple similaire à la couche arrière 102 précédemment décrite en liaison avec le biocapteur 100, une couche diélectrique 204 et une couche de diamant dopé. La couche diélectrique 204 est disposée entre la couche de diamant dopé et la couche arrière 202. La couche arrière 202 a par exemple une épaisseur égale à environ 700 µm. Dans une variante, la couche arrière 202 peut être remplacée par les couches d'un substrat SOI (semi-conducteur sur isolant) tel que la couche diélectrique 204, dont l'épaisseur est par exemple comprise entre environ 70 nm et 1 µm, soit disposée entre la couche de diamant dopé et la couche superficielle de semi-conducteur du substrat SOI.

Comme représenté sur la figure 2A, des électrodes de diamant dopé sont réalisées sur la couche diélectrique 204, en gravant la couche de diamant dopé. Sur la figure 2A, une seule électrode 208, correspondant à l'électrode de mesure du biocapteur 200, est représentée.

La couche diélectrique 204 est destinée à réduire le plus possible le couplage pouvant apparaitre entre la couche arrière 102 et l'électrode de mesure 208 lorsqu'un signal est appliqué sur l'électrode de mesure 208, ce couplage représentant une source de bruit parasite dans la mesure réalisée par le biocapteur 200. Ainsi, l'épaisseur de la couche diélectrique 204 peut être choisie supérieure ou égale à environ 50 nm.

La couche diélectrique 204 est ensuite gravée afin de ne conserver que des portions de la couche diélectrique 204 se trouvant sous les électrodes du biocapteur 200, libérant la surface de semi-conducteur de la couche arrière 102 se trouvant à côté des électrodes. Sur l'exemple de la figure 2B, une portion restante 210 de la couche diélectrique 204 est disposée sous l'électrode de mesure 208. Un matériau barrière, par exemple de nature similaire à celui de la couche barrière 106 du biocapteur 100 (matériau diélectrique, diamant intrinsèque, ...), permettant d'empêcher la diffusion d'oxygène à haute température dans les électrodes de diamant lors de la réalisation des circuits électroniques du biocapteur 200, est déposé sur les électrodes de diamant dopé du biocapteur 200, formant, sur la figure 2B, une couche 212 de matériau barrière recouvrant l'électrode de mesure 208 et la portion diélectrique 210. La couche 212 de matériau barrière a par exemple une épaisseur égale à environ 1 µm. Les circuits électroniques du biocapteur 200 sont ensuite réalisés sur les portions de la couche arrière 202 se trouvant à côté des électrodes, par la mise en oeuvre d'étapes standards de microélectronique. Sur la figure 2B, un seul transistor MOS d'un circuit électronique 214 est représenté.

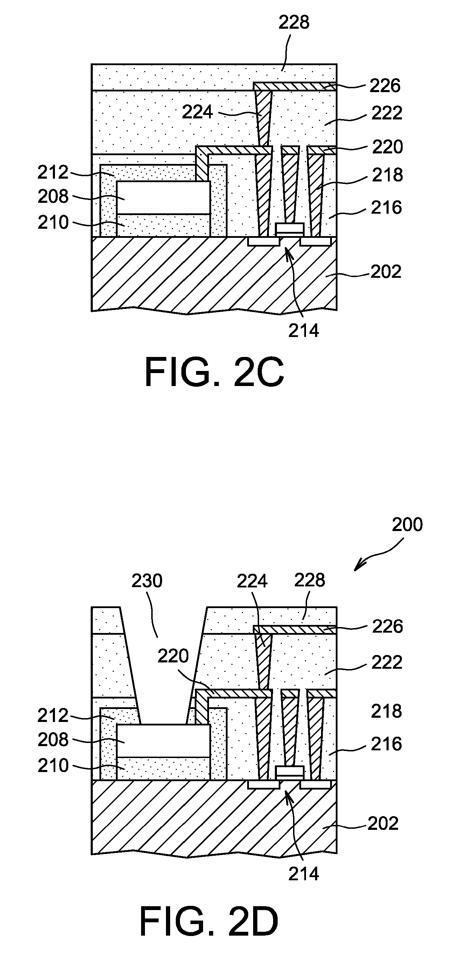

De manière analogue au biocapteur 100, on réalise ensuite des interconnexions électriques sur plusieurs niveaux afin de relier électriquement les électrodes du biocapteur 200 au circuit électronique 214. Sur l'exemple de la figure 2C, ces interconnexions sont obtenues par l'intermédiaire de couches de passivation 216, 222, 228, de vias traversant 218, 224 et de couches d'interconnexions 220, 226, réalisés par exemple de manière analogue aux éléments correspondants du biocapteur 100.

Enfin, les électrodes de diamant dopé du biocapteur 200 sont libérées en perçant localement, par exemple par gravure, les couches de passivation 228, 222, 216 et la couche de matériau barrière 212, formant un trou 230 et mettant à nue la face supérieure de l'électrode de mesure 208 (figure 2D).

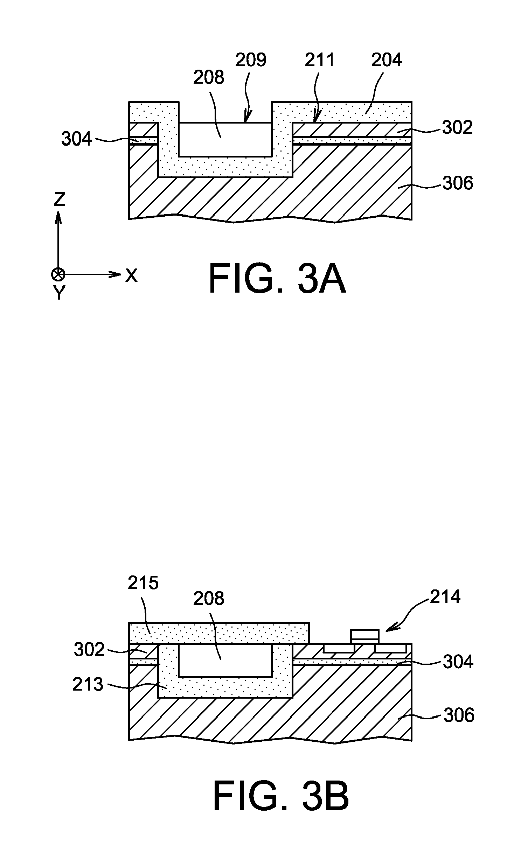

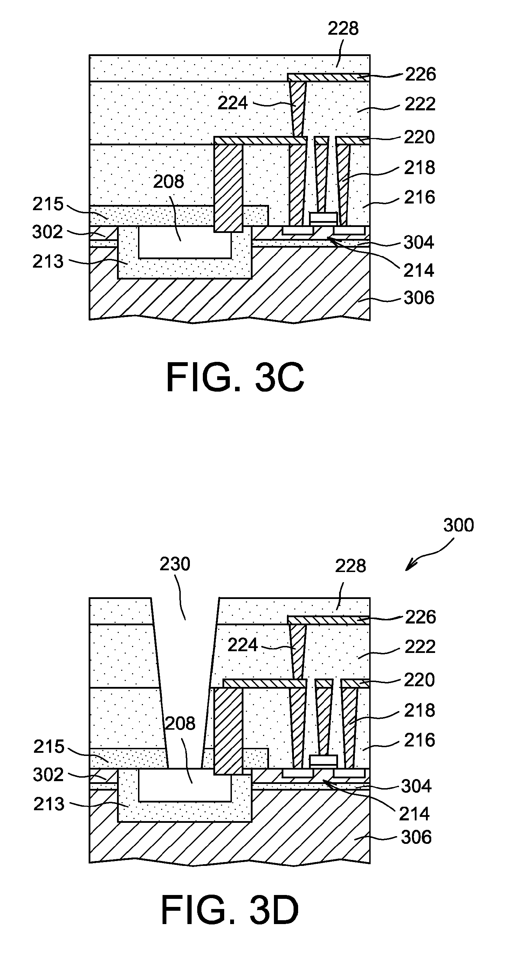

On se réfère maintenant aux figures 3A à 3D qui représente les étapes d'un procédé de réalisation d'un capteur biologique à mesure électrochimique 300 selon un troisième mode de réalisation. Sur ces figures 3A à 3D, seule la réalisation d'une partie du biocapteur 300 est représentée.

Comme représenté sur la figure 3A, le biocapteur 300 est réalisé à partir d'un substrat comportant la couche diélectrique 204 disposée sur les couches d'un substrat SOI (semi-conducteur sur isolant) comportant une couche superficielle 302 à base d'un matériau semi-conducteur, une couche diélectrique 304 et une couche massive 304 par exemple à base de semi-conducteur. Des creux sont réalisés dans les couches 302, 304 et 306 du substrat SOI, dans lesquels la couche diélectrique 204 et la couche de diamant dopé sont disposés. Les portions de cette couche de diamant se trouvant dans ces creux forment les électrodes du biocapteur 300. Sur la figure 3A, seule une électrode de mesure 208 est représentée. Une face supérieure 209 de l'électrode de mesure 208 peut donc se trouver dans un même plan, parallèle au plan (X,Y) représenté sur la figure 3A, que celui dans lequel se trouve une face supérieure 211 de la couche superficielle de semi-conducteur 302.

De manière analogue au procédé de réalisation du biocapteur 200 précédemment décrit, on grave des portions de la couche diélectrique 204 ne se trouvant pas sous les électrodes, puis on réalise le dépôt d'un matériau barrière 215 recouvrant notamment l'électrode de mesure 208. On réalise ensuite les circuits électroniques du biocapteur 300 (symbolisé par le transistor d'un circuit électronique 214 sur la figure 3B) sur la surface de la couche de semi-conducteur 302. Les interconnexions électriques reliant électriquement les électrodes au circuit électronique 214 du biocapteur 300 sont ensuite réalisées de manière analogue à celles précédemment décrites pour le biocapteur 200 (figure 3C). Enfin, un trou 230 est formé à travers les couches de passivation 216, 222, 226 et la couche barrière 215, formant un accès à l'électrode de mesure 208.

Par rapport au biocapteur 200, un tel biocapteur 300, dans lequel les électrodes sont réalisées dans des creux, permet d'éviter les problèmes de topologie de surface qui pourraient apparaître si les électrodes du biocapteur étaient formées au-dessus de la couche de semi-conducteur 302.

## Revendications

1. Capteur biologique (100, 200, 300) à mesure électrochimique et/ou électrique comprenant au moins :
- une électrode de mesure (112, 208) apte à réaliser une mesure électrochimique et/ou électrique et comportant au moins une portion (112, 208) d'une couche de diamant dopée (104) d'un substrat comportant un empilement comprenant au moins une couche diélectrique (106, 204) disposée entre la couche de diamant dopée (104) et une couche de matériau semi-conducteur (108, 202, 302),
- un circuit électronique (114, 214) d'amplification et/ou de traitement d'au moins un signal électrique destiné à être délivré par l'électrode de mesure (112, 208), relié électriquement à l'électrode de mesure (112, 208) et réalisé dans une portion de la couche de matériau semi-conducteur (108, 202, 302).

2. Capteur (100) selon la revendication 1, dans lequel le substrat est du type SOD.

3. Capteur (100) selon la revendication 2, dans lequel la couche de matériau semi-conducteur (108) a une épaisseur inférieure ou égale à environ 1 µm, le circuit électronique (114) comportant un ou plusieurs transistors de type PD-SOI ou FD-SOI.

4. Capteur (100) selon la revendication 2 ou 3, dans lequel l'électrode de mesure (112) est délimitée du reste de la couche de diamant (104) par des tranchées (110) remplies d'au moins un matériau diélectrique et traversant au moins la couche de diamant (104).

5. Capteur (100) selon l'une des revendications 2 à 4, dans lequel le circuit électronique (114) est relié électriquement à l'électrode de mesure (112) par des vias traversant (118) et au moins une couche d'interconnexions électriques (120) à base d'au moins un matériau électriquement conducteur formés dans au moins une couche de passivation (116, 122, 128) à base d'au moins un matériau diélectrique, la couche de matériau semi-conducteur (108) étant disposée entre la couche de diamant (104) et la couche de passivation (116, 122, 128).

6. Capteur (100) selon la revendication 5, dans lequel la couche de passivation (116, 122, 128) est disposée entre une couche massive (130) formant un support mécanique du capteur (100) et la couche de semi-conducteur (108).

7. Capteur (100) selon la revendication 5, dans lequel au moins un trou (132) réalisé à travers au moins la couche de passivation (116, 122, 128), la couche de matériau semi-conducteur (108) et la couche diélectrique (106) forme un accès à l'électrode de mesure (112).

8. Capteur (200, 300) selon la revendication 1, dans lequel le circuit électronique (214) est relié électriquement à l'électrode de mesure (208) par des vias traversant (218) et au moins une couche d'interconnexions électriques (220) à base d'au moins un matériau électriquement conducteur formés dans au moins une couche de passivation (216, 222, 228) à base d'au moins un matériau diélectrique disposée contre la couche de matériau semi-conducteur (202, 302), et dans lequel au moins un trou (230) réalisé à travers au moins la couche de passivation (216, 222, 228) forme un accès à l'électrode de mesure (208).

9. Capteur (300) selon la revendication 1 ou 8, dans lequel l'électrode de mesure (208) est disposée dans un creux formé au moins dans la couche de semi-conducteur (202, 302).

10. Capteur (100, 200, 300) selon l'une des revendications précédentes, dans lequel des récepteurs biologiques complémentaires des molécules destinées à être détectées par le capteur (100, 200, 300) sont greffées sur l'électrode de mesure (112, 208).

11. Capteur (100, 200, 300) selon l'une des revendications précédentes, comportant en outre une seconde électrode formant une électrode de référence, ou une deuxième et une troisième électrodes formant respectivement une électrode de référence et une contre-électrode, chaque électrode du capteur (100, 200, 300) comportant au moins une portion de la couche de diamant (104).

12. Procédé de réalisation d'un capteur biologique (100, 200, 300) à mesure électrochimique et/ou électrique comportant au moins les étapes de :
- réalisation d'une électrode de mesure (112, 208) apte à réaliser une mesure électrochimique et/ou électrique et comportant au moins une portion (112, 208) d'une couche de diamant dopée (104) d'un substrat comportant un empilement comprenant au moins une couche diélectrique (106, 204) disposée entre la couche de diamant dopée (104) et une couche de matériau semi-conducteur (108, 202, 302),
- réalisation, dans une portion de la couche de matériau semi-conducteur (108, 202, 302), d'un circuit électronique (114, 214) d'amplification et/ou de traitement d'un signal électrique destiné à être délivré par l'électrode de mesure (112, 208),
- réalisation d'une liaison électrique (118, 120, 218, 220) au moins entre l'électrode de mesure (112, 208) et le circuit électronique (114, 214).

13. Procédé selon la revendication 12, dans lequel la réalisation de l'électrode de mesure (112) est obtenue par la mise en oeuvre au moins des étapes suivantes :
- gravure de tranchées (110) au moins à travers la couche de diamant (104), la couche de matériau semi-conducteur (108) et la couche diélectrique (106), délimitant une portion (112) de la couche de diamant (104) destinée à former l'électrode de mesure (112),
- remplissage des tranchées (110) par au moins un matériau diélectrique.

14. Procédé selon la revendication 12 ou 13, dans lequel la réalisation de la liaison électrique (118, 120) entre l'électrode de mesure (112) et le circuit électronique (114) est obtenue par la mise en oeuvre au moins des étapes suivantes :
- dépôt d'au moins une couche de passivation (116) à base d'au moins un matériau diélectrique sur la couche de matériau semi-conducteur (108), recouvrant le circuit électronique (114),
- réalisation de vias traversant (118) à base d'au moins un matériau électriquement conducteur reliés électriquement à l'électrode de mesure (112) et au circuit électronique (114) à travers au moins la couche de passivation (116),
- réalisation d'une couche d'interconnexions électriques (120) à base d'au moins un matériau électriquement conducteur sur la couche de passivation (116), telle qu'au moins une portion de la couche d'interconnexions électriques (120) et les vias traversant (118) relient électriquement l'électrode de mesure (112) au circuit électronique (110).

15. Procédé selon la revendication 14, comportant en outre, après la réalisation de la liaison électrique (118, 120) entre l'électrode de mesure (112) et le circuit électronique (114), une étape de dépôt d'au moins une seconde couche de passivation (122, 128) recouvrant au moins la couche d'interconnexions électriques (120), puis une étape de solidarisation de la seconde couche de passivation (128) avec une couche massive (130) formant un support mécanique du capteur (100).

16. Procédé selon la revendication 14, comportant en outre, après la réalisation de la liaison électrique (118, 120) entre l'électrode de mesure (112) et le circuit électronique (114), une étape de gravure d'au moins un trou (132) à travers au moins la couche de passivation (116, 122, 128), la couche de matériau semi-conducteur (108) et la couche diélectrique (106), formant un accès à l'électrode de mesure (112).

17. Procédé selon la revendication 12, dans lequel la réalisation de l'électrode de mesure (208) est obtenue par la mise en oeuvre au moins d'une étape de gravure de la couche de diamant.

18. Procédé selon la revendication 12, dans lequel la réalisation de l'électrode de mesure (208) est obtenue par la mise en oeuvre au moins d'une étape de dépôt de la couche de diamant sur la couche diélectrique (204), la couche de diamant et au moins une portion (213) de la couche diélectrique (204) étant disposées dans un creux formé au moins dans la couche de matériau semi-conducteur (202, 302).

19. Procédé selon la revendication 17 ou 18, comportant en outre, entre l'étape de réalisation de l'électrode de mesure (208) et l'étape de réalisation du circuit électronique (214), une étape de gravure de la couche diélectrique (204) telle qu'au moins une portion restante (210, 213) de la couche diélectrique (204) soit disposée entre l'électrode de mesure (208) et la couche de semi-conducteur (202, 302), puis d'une étape de dépôt d'un matériau diélectrique (212, 215) recouvrant au moins l'électrode de mesure (208).

20. Procédé selon l'une des revendications 17 à 19, dans lequel la réalisation de la liaison électrique (218, 220) entre l'électrode de mesure (208) et le circuit électronique (214) est obtenue par la mise en oeuvre au moins des étapes suivantes :
- dépôt d'au moins une couche de passivation (216) à base d'au moins un matériau diélectrique sur la couche de matériau semi-conducteur (202, 302), recouvrant le circuit électronique (214) et l'électrode de mesure (208),
- réalisation de vias traversant (218) à base d'au moins un matériau électriquement conducteur reliés électriquement à l'électrode de mesure (208) et au circuit électronique (214) à travers au moins la couche de passivation (216),
- réalisation d'une couche d'interconnexions électriques (220) à base d'au moins un matériau électriquement conducteur sur la couche de passivation (216), telle qu'au moins une portion de la couche d'interconnexions électriques (220) et les vias traversant (218) relient électriquement l'électrode de mesure (208) au circuit électronique (214).

21. Procédé selon la revendication 20, comportant en outre, après la réalisation de la liaison électrique (218, 220) entre l'électrode de mesure (208) et le circuit électronique (214), une étape de gravure d'au moins un trou (230) à travers au moins la couche de passivation (216), formant un accès à l'électrode de mesure (208).

22. Procédé selon l'une des revendications 12 à 21, dans lequel la ou les étapes mises en oeuvre pour la réalisation de l'électrode de mesure (112, 208) réalisent également une seconde électrode formant une électrode de référence, ou une deuxième et une troisième électrodes formant respectivement une électrode de référence et une contre-électrode, chaque électrode du capteur (100, 200, 300) comportant au moins une portion de la couche de diamant (104).

23. Procédé selon l'une des revendications 12 à 22, comportant en outre une étape de greffage de récepteurs biologiques complémentaires de molécules destinées à être détectées par le capteur (100, 200, 300) sur l'électrode de mesure (112, 208).
